# EUROPÄISCHE PATENTSCHRIFT

(11) **EP 3 036 980 B1**
(45) Veröffentlichungstag und Bekanntmachung des Hinweises auf die Patenterteilung: **10.10.2018**
(21) Anmeldenummer: 14741924.6
(22) Anmeldetag: 23.07.2014
(51) Int. Cl.: H05K 7/14

(54) **SERVEREINSCHUB FÜR EIN SERVERRACK**
SERVER INSERT FOR A SERVER RACK
TIROIR DE SERVEUR POUR RACK DE SERVEURS

(30) Priorität: 23.08.2013 DE 102013109164
(43) Veröffentlichungstag der Anmeldung: 29.06.2016
(73) Patentinhaber: Fujitsu Limited, Kawasaki-shi Kanagawa 211-8588 (JP)
(72) Erfinder: SCHELSHORN, Lorenz, 86179 Augsburg (DE); KÖHLER, Friedrich, 86179 Augsburg (DE)
(74) Vertreter: Epping - Hermann - Fischer
(86) Internationale Anmeldenummer: PCT/EP2014/065852
(87) Internationale Veröffentlichungsnummer: WO 2015/024728

(56) Entgegenhaltungen:
- US-A1- 2003 206 398
- US-A1- 2005 211 456
- US-A1- 2006 164 814
- US-A1- 2009 296 322

## Beschreibung

Die Erfindung betrifft einen Servereinschub für ein Serverrack, aufweisend ein Einschubgehäuse mit einem Gehäuseboden und eine Einbaukäfigvorrichtung.

Ein Serverrack umfasst im Allgemeinen eine Vielzahl von Servern, die Form von Einschubmodulen in einen oder mehrere Serverrahmen des Serverracks eingeschoben sind und daher auch als Servereinschübe bezeichnet werden können. Die Servereinschübe umfassen dabei in der Regel einen oder mehrere Prozessoren und Speicherbausteine sowie Einschubkomponenten, beispielsweise Festplattenspeicherlaufwerke. Die Einschubkomponenten sind dabei in der Regel von einer Vorderseite des Servereinschubs beziehungsweise des Serverracks zugänglich und in einen oder mehreren Einbaukäfigen innerhalb eines Servereinschubs einschiebbar.

Aus der US 2003/206398 A1 ist ein Computer bekannt, der ein Chassis mit einem Anschlagselement und mit einem Ausrichteelement benachbart zu dem Anschlagselement aufweist. Aus der US 2009/296322 A1 ist eine Gehäuseeinheit für ein Speichermedium bekannt, welche ein Hauptgehäuse mit einer Aufnahmekammer, eine Nebengehäuse, welches in der Aufnahmekammer montiert ist, und eine Leiterplatte aufweist, welche an dem Nebengehäuse montiert ist.
Aus der US 2006/164814 A1 ist ein herausnehmbarer Käfig für ein Computerchassisaufbau bekannt. Der Käfig umfasst einen Rahmen mit einem Boden, einem Deckel und zwei Seitenwänden. Weiter ist eine Midplane vorgesehen, die an dem Rahmen zur Bereitstellung eines Montageplatzes für zumindest ein Laufwerk gekoppelt ist.

Aus der US 2005/211456 A1 ist ein elektronisches Gerät bekannt, welches ein oder mehrere elektrische Komponenten aufweist, die in einem Gehäuse aufgenommen sind.

Eine Aufgabe, die der Erfindung zugrunde liegt, ist es, einen Servereinschub für ein Serverrack anzugeben, welcher sich durch einen einfachen konstruktiven Aufbau und eine hohe mechanische Stabilität auszeichnet.

Die Aufgabe wird gelöst durch die Merkmale des unabhängigen Patentanspruchs. Vorteilhafte Ausgestaltungen sind in den Unteransprüchen angegeben.

Die Erfindung zeichnet sich durch einen Servereinschub für ein Serverrack aus, welcher ein Einschubgehäuse mit einem Gehäuseboden aufweist. Der Servereinschub weist des Weiteren eine Einbaukäfigvorrichtung zur Aufnahme von Einschubkomponenten auf, welche innerhalb des Einschubgehäuses an dem Gehäuseboden angeordnet ist und sich im Wesentlichen über eine gesamte Breite des Einschubgehäuses erstreckt. Des Weiteren weist der Servereinschub eine Leiterplatte, insbesondere eine Back- oder Midplane auf, welche im Wesentlichen senkrecht zu dem Gehäuseboden an der Einbaukäfigvorrichtung zur mechanischen Versteifung dieser kraftschlüssig festgelegt ist, so dass die Einbaukäfigvorrichtung über die Breite des Einschubgehäuses eine versteifte Einheit bildet und eine Versteifung des Einschubgehäuses bewirkt wird. Die Leiterplatte ist formschlüssig an dem Gehäuseboden angeordnet, sodass die Leiterplatte beim Einschieben von Einschubkomponenten vor einer Durchbiegung in einer Einschubrichtung geschützt ist.

Einbaukäfigvorrichtungen dienen in der Regel der Aufnahme einer Vielzahl von Einschubkomponenten, wie beispielsweise Festplattenlaufwerken, wodurch ein hohes Gewicht auf die Einbaukäfigvorrichtung und somit auf den Gehäuseboden des Einschubgehäuses wirkt. Zum Erreichen einer möglichst platzsparenden Ausgestaltung des Einschubgehäuses und der Einbaukäfigvorrichtung werden verhältnismäßig dünne Metallbleche als Gehäusekomponenten verwendet, so dass es aufgrund des Gewichts zu einer Durchbiegung der Einbaukäfigvorrichtung und somit des Gehäusebodens kommen könnte.

Dadurch, dass in dem Servereinschub die Leiterplatte kraftschlüssig an der Einbaukäfigvorrichtung festgelegt ist, ist die Einbaukäfigvorrichtung in sich versteift. Insbesondere ist die Leiterplatte dabei in mehreren Seitenbereichen der Einschubkäfigvorrichtung an dieser kraftschlüssig festgelegt. Die Einbaukäfigvorrichtung bildet somit über eine gesamte Breite des Einschubgehäuses eine versteifte Einheit, wodurch eine Durchbiegung des Gehäusebodens im Wesentlichen verhindert ist. Die Leiterplatte ist in der Regel aus stabilem Leiterplattenmaterial gefertigt, sodass diese die entstehenden Biege- und/oder Gewichtskräfte aufnehmen kann.

Durch das kraftschlüssige Anbringen der Leiterplatte an der Einbaukäfigvorrichtung kann insbesondere auf eine zusätzliche Trägerbrücke, beispielsweise aus einem Metallwerkstoff, zum Versteifen des Einschubgehäuses beziehungsweise der Einbaukäfigvorrichtung verzichtet werden. Durch die beanspruchte Ausgestaltung können das Gewicht und die Herstellungskosten bei Beibehaltung der mechanischen Stabilität verringert werden. Zusätzlich ist eine bessere Handhabung bei der Montage von Einschub- oder den anderen Komponenten des Servereinschubs gegeben, da mehr Bauraum innerhalb des Einschubgehäuses des Servereinschubs zur Verfügung steht.

Servereinschübe benötigen die Leiterplatte in der Regel für das sogenannte Hot-Plugging, bei welchen die Einschubkomponenten während des laufenden Betriebs ausgetauscht oder ausgewechselt werden können. Beispielsweise können Festplattenlaufwerke in die Einbaukäfigvorrichtung eingeschoben und mittels einer Direktsteckverbindung mit der Leiterplatte kontaktiert werden. Dabei ist es notwendig, dass die Leiterplatte die beim Einschieben entstehenden Kräfte aufnimmt und an das Einschubgehäuse abgibt, so dass die Leiterplatte nicht in Einschubrichtung der Einschubkomponenten durchgebogen und beschädigt wird. Dazu ist die Leiterplatte zusätzlich formschlüssig an dem Gehäuseboden angeordnet, so dass diese vor einer Durchbiegung in Einschubrichtung geschützt ist.

Gemäß einer Ausgestaltung weist die Einbaukäfigvorrichtung zwei oder mehrere Einbaukäfige, insbesondere Festplattenkäfige, auf, wobei die Leiterplatte derart kraftschlüssig an der Einbaukäfigvorrichtung festgelegt ist, dass die Leiterplatte die Einbaukäfige mechanisch verbindet und die Einbaukäfige versteift. Dadurch sind die Einbaukäfige relativ zueinander versteift und bilden eine Einheit. Dies verhindert eine Durchbiegung der Einbaukäfige beziehungsweise der Einheit selbst und somit eine Durchbiegung des Gehäusebodens.

Gemäß einer Ausgestaltung ist die Leiterplatte an dem Gehäuseboden kraftschlüssig festgelegt. Dadurch ist die Leiterplatte auch mechanisch sicher an dem Gehäuseboden festgelegt. Zudem ist eine höhere mechanische Stabilität gewährleistet, insbesondere vor einem Durchbiegen der Leiterplatte in Einschubrichtung der Einschubkomponenten.

Gemäß einer weiteren Ausgestaltung ist die Leiterplatte formschlüssig an der Einbaukäfigvorrichtung angeordnet. Die Leiterplatte ist also nicht nur kraftschlüssig an der Einbaukäfigvorrichtung festgelegt, sondern auch formschlüssig, wodurch zusätzliche Steifigkeit erreicht werden kann. Zusätzlich wird dadurch die Montage der Leiterplatte an der Einbaukäfigvorrichtung verbessert oder vereinfacht, da eine kraft- und formschlüssige Montage weniger aufwändig als eine rein kraftschlüssige Montage, beispielsweise mittels Schraubverbindungen, ist. Insbesondere kann auf einen Teil der Schraubverbindungen aufgrund des zusätzlichen Formschlusses verzichtet werden.

Gemäß einer weiteren Ausgestaltung weist der Gehäuseboden wenigstens eine Nut und/oder wenigstens eine Kulissenführung zur formschlüssigen Aufnahme einer Unterseite der Leiterplatte auf. Hierdurch ist eine einfache Möglichkeit für den Formschluss zwischen der Leiterplatte und dem Gehäuseboden gegeben. Derartige Ausgestaltungen eines Formschlusses sind in der Regel von einfacher Geometrie und deshalb leicht herzustellen und zu montieren.

Gemäß einer weiteren Ausgestaltung ist die Leiterplatte an zwei gegenüberliegenden und zu dem Gehäuseboden senkrecht angeordneten Gehäusewänden des Einschubgehäuses formschlüssig angeordnet. Dadurch wird die mechanische Festlegung der Leiterplatte in dem Einschubgehäuse weiter begünstigt.

Gemäß einer weiteren Ausgestaltung weisen die Gehäusewände jeweils wenigstens eine Nut und/oder wenigstens eine Kulissenführung zur formschlüssigen Aufnahme der Leiterplatte auf. Derartige Ausgestaltungen eines Formschlusses sind in der Regel von einfacher Geometrie und deshalb leicht herzustellen und zu montieren.

Gemäß einer weiteren Ausgestaltung weist die Einbaukäfigvorrichtung einen oder mehrere Dorne, insbesondere Führungs- und/oder Schraubdorne auf, welche dazu ausgebildet sind, in eine oder mehrere entsprechende Öffnungen der Leiterplatte formschlüssig einzugreifen. Schraubdorne oder Führungsdorne gewährleisten einfache Möglichkeiten, wie der Formschluss zwischen der Leiterplatte und der Einbaukäfigvorrichtung verwirklicht werden kann. Dazu sind die Schraub- oder Führungsdorne lediglich in die Einbaukäfigvorrichtung eingeschraubt oder eingesteckt, sodass die Leiterplatte formschlüssig auf die Schraub- oder Führungsdorne aufgeschoben oder aufgesteckt werden kann.

Weitere Ausgestaltungen sind in der nachfolgenden, ausführlichen Beschreibung eines Ausführungsbeispiels offenbart.

Die Erfindung wird nachfolgend anhand des Ausführungsbeispiels unter Bezugnahme auf die angehängten Figuren näher erläutert. In den Figuren zeigen:
- Figur 1: eine perspektivische Darstellung eines Servereinschubs und
- Figur 2: eine Aufsicht auf den Servereinschub von hinten.

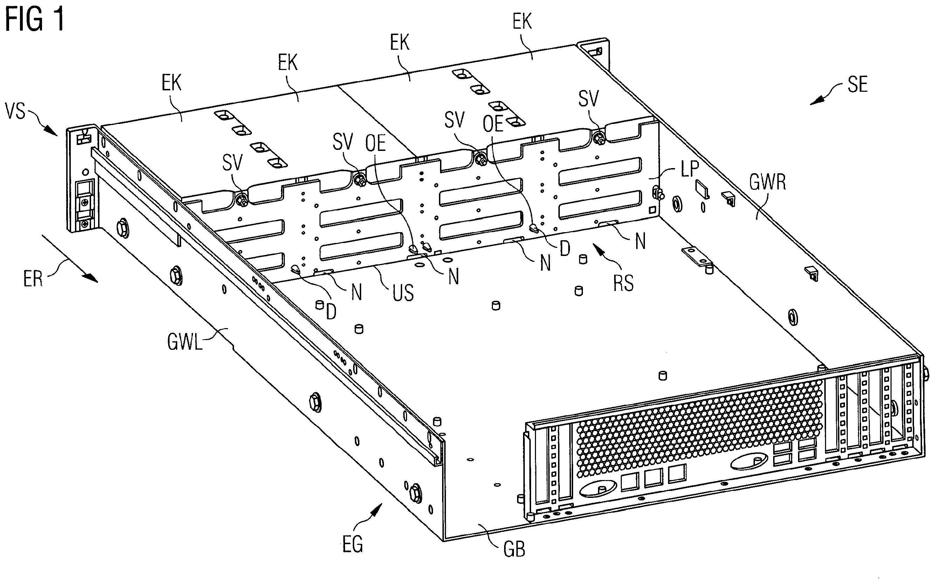

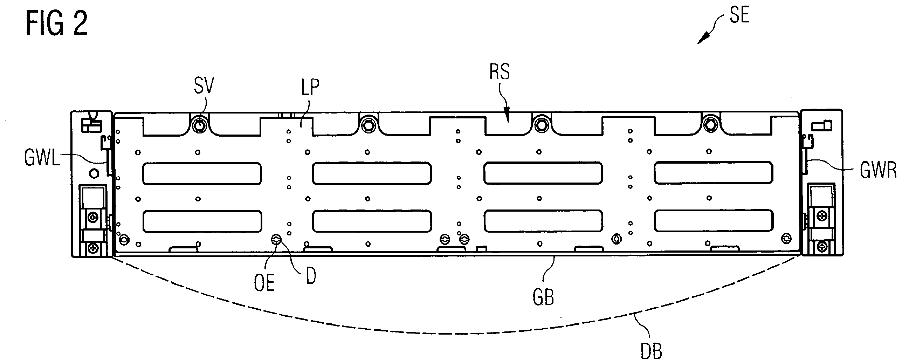

Figuren 1 und 2 zeigen einen Servereinschub SE für ein Serverrack. Der Servereinschub SE besitzt ein Einschubgehäuse EG, welches einen Gehäuseboden GB, eine linke Gehäusewand GWL sowie eine rechte Gehäusewand GWR aufweist. Die beiden Gehäusewände GWR und GWL sind gegenüber dem Gehäuseboden GB um 90° in Normalenrichtung abgebogen.

Im Inneren des Einschubgehäuses EG, dessen Gehäusedeckel aus Übersichtlichkeitsgründen nicht gezeigt ist, sind mehrere Einbaukäfige EK angeordnet. Die Einbaukäfige EK können auch als Einbaukäfigvorrichtung bezeichnet werden. Die Einbaukäfige EK befinden sich dabei im Bereich einer Vorderseite VS des Servereinschubs SE. Die Einbaukäfige EK beinhalten im Ausführungsbeispiel Festplattenlaufwerke (nicht dargestellt). Alternativ können auch andere Einschubkomponenten innerhalb der Einbaukäfige EK montiert oder angeordnet sein. Die Festplattenlaufwerke beziehungsweise Einschubkomponenten sind von der Vorderseite VS des Servereinschubs SE zugänglich und können beispielsweise in einer Einschubrichtung ER in einen Einbaukäfig EK eingeführt beziehungsweise eingesteckt werden. Zusätzlich ist im Inneren des Servereinschubs SE eine Leiterplatte LP angeordnet. Weitere Komponenten, welche für den Betrieb eines Servereinschubs SE notwendig sind, sind aus Gründen der Übersichtlichkeit nicht dargestellt.

Die Leiterplatte LP ist direkt und kraftschlüssig an Rückseiten RS der Einbaukäfige EK beziehungsweise der Einbaukäfigvorrichtung festgelegt. Im Ausführungsbeispiel ist die Leiterplatte LP über Schraubverbindungen SV mit jedem der Einbaukäfige EK verschraubt. Alternativ sind auch andere mechanische Verbindungstechniken denkbar und möglich. Dabei ist die Leiterplatte in Seitenbereichen der Einbaukäfige EK mit diesen verschraubt. Insbesondere ist die Leiterplatte in oberen Seitenbereichen der Einbaukäfige EK, welche von dem Gehäuseboden GB abgewandt sind, mit den Einbaukäfigen EK verschraubt. Die Leiterplatte LP ist über eine gesamte Breite des Einschubgehäuses EG mit den Einbaukäfigen EK beziehungsweise mit der Einbaukäfigvorrichtung verbunden.

Zusätzlich ist die Leiterplatte LP formschlüssig an jedem der Einbaukäfige EK angeordnet. Hierzu sind mehrere Öffnungen OE in die Leiterplatte LP eingebracht, durch welche Dorne D geführt sind. Die Dorne D sind dabei mechanisch fest an den Einbaukäfigen EK festgelegt, beispielsweise mit den Einbaukäfigen EK verschraubt. Die Dorne D sind dabei an Seitenbereichen der Einbaukäfige EK beziehungsweise Einbaukäfigvorrichtung angeordnet, insbesondere an unteren Seitenbereichen, welche dem Gehäuseboden GB zugewandt sind. Die Dorne D sind Führungs- und Schraubdorne. Andere Ausgestaltungen, wie beispielsweise Metalllaschen, welche in Öffnungen der Leiterplatte LP eingreifen, sind alternativ möglich.

Die Leiterplatte LP verbindet die Einbaukäfige EK mechanisch und versteift die Einbaukäfige EK somit in Längserstreckung der Leiterplatte LP. Dies bedeutet, dass die Einbaukäfige EK gegen eine Durchbiegung DB in Normalenrichtung des Gehäusebodens GB, welche schematisch in der zweidimensionalen Ansicht der Figur 2 gezeigt ist, von links nach rechts beziehungsweise von der linken Gehäusewand GWL zur rechten Gehäusewand GWR versteift sind. Die Versteifung ist notwendig, damit die Durchbiegung DB des Gehäusebodens GB aufgrund eines Gewichts der im Inneren der Einbaukäfige EK angeordneten Festplattenlaufwerke verhindert wird. Die Einbaukäfige EK sind in der Regel aus dünnen Metallblechen gefertigt, welche sich leicht unter dem Gewicht der Festplattenlaufwerke elastisch verformen lassen. Dadurch würde es zu der schematisch gezeigten Durchbiegung DB kommen, welche insbesondere beim Einschieben des Servereinschubs SE in ein Serverrack Probleme verursacht.

In der Regel sind mehrere Servereinschübe dicht gepackt in einem Serverrack übereinander angeordnet, sodass beim Einschieben eines Servereinschubs SE aufgrund der Durchbiegung DB darunterliegende Servereinschübe beschädigt würden. Dies liegt daran, dass aufgrund eines durchgebogenen Gehäusebodens GB der Servereinschub SE insgesamt eine Höhe einnehmen würde, welche größer als eine maximale Höhe ist und der Gehäuseboden GB beim Einschieben einen darunterliegenden Servereinschub SE berühren würde. Neben einem Beschädigen des darunterliegenden Servers wäre auch das Einscheiben selbst schwergängiger.

Die Durchbiegung DB wird durch die Leiterplatte LP im Ausführungsbeispiel gemäß den Figuren 1 und 2 verhindert, sodass die Gewichtskräfte über die Leiterplatte LP kompensiert werden. Eine zusätzliche Komponente, wie beispielsweise eine Versteifungsbrücke aus Metall, welche zwischen der linken Gehäusewand und der rechten Gehäusewand GWL beziehungsweise GWR in dem Einschubgehäuse EG montiert ist, kann entfallen.

Es sei darauf hingewiesen, dass dieser Formschluss alternativ nicht zwingend notwendig ist, wenn eine ausreichende kraftschlüssige Verbindung zwischen der Leiterplatte LP und den Einbaukäfigen EK hergestellt ist. Es gilt lediglich zu beachten, dass die Einbaukäfigvorrichtung über eine gesamte Breite des Einschubgehäuses EG mechanisch versteift ist beziehungsweise jeder Einbaukäfig EK über die Leiterplatte LP mechanisch verbunden ist, sei es durch Formschluss und/oder Kraftschluss.

Damit die Festplattenlaufwerke direkt mit der Leiterplatte LP kontaktiert werden können, beispielsweise für das sogenannte Hot-Plugging, ist die Leiterplatte LP zusätzlich formschlüssig an dem Gehäuseboden GB angeordnet. Dazu sind an dem Gehäuseboden Nuten N oder anderweitige Führungen wie Kulissenführungen angeordnet, welche eine Unterseite US der Leiterplatte formschlüssig aufnehmen. Somit ist die Leiterplatte LP selbst gegen ein Durchbiegen in der Einschubrichtung ER der Einschubkomponenten geschützt.

In einer alternativen, nicht gezeigten Ausführungsform kann die Leiterplatte LP auch an dem Gehäuseboden GB mechanisch kraftschlüssig festgelegt sein, beispielsweise mittels Schraubverbindungen. Dies begünstigt die mechanische und sichere Festlegung der Leiterplatte LP innerhalb des Einschubgehäuses EG weiter.

In einer weiteren alternativen, nicht gezeigten Ausführungsform ist die Leiterplatte LP an der linken Gehäusewand GWL und/oder rechten Gehäusewand GWL des Einschubgehäuses EG angeordnet. Dies lässt sich beispielsweise mittels zusätzlicher Nuten oder Kulissenführungen verwirklichen. Eine derartige Anordnung unterstützt die Leiterplatte LP zur Kraftaufnahme zusätzlich, sodass die von der Leiterplatte LP in Einschubrichtung ER aufgenommenen Kräfte über das Einschubgehäuse EG abgeleitet werden können.

### Bezugszeichenliste

- D: Dorn
- DB: Durchbiegung
- EG: Einschubgehäuse
- EK: Einbaukäfig
- ER: Einschubrichtung
- GB: Gehäuseboden
- GWL: linke Gehäusewand
- GWR: rechte Gehäusewand
- LP: Leiterplatte
- N: Nut
- OE: Öffnung
- RS: Rückseite
- SE: Servereinschub
- SV: Schraubverbindung
- US: Unterseite
- VS: Vorderseite

## Patentansprüche

1. Servereinschub (SE) für ein Serverrack, aufweisend
- ein Einschubgehäuse (EG) mit einem Gehäuseboden (GB);
- eine Einbaukäfigvorrichtung zur Aufnahme von Einschubkomponenten, welche innerhalb des Einschubgehäuses (EG) an dem Gehäuseboden (GB) angeordnet ist und sich im Wesentlichen über eine gesamte Breite des Einschubgehäuses (EG) erstreckt; und
- eine Leiterplatte (LP), insbesondere eine Back- oder Midplane, wobei die Leiterplatte (LP) im Wesentlichen senkrecht zu dem Gehäuseboden (GB) in mehreren Seitenbereichen an der Einbaukäfigvorrichtung zur mechanischen Versteifung dieser kraftschlüssig festgelegt ist, so dass die Einbaukäfigvorrichtung über die Breite des Einschubgehäuses (EG) eine versteifte Einheit bildet und eine Versteifung des Einschubgehäuses (EG) bewirkt wird, und wobei die Leiterplatte formschlüssig an dem Gehäuseboden (GB) angeordnet ist, so dass die Leiterplatte beim Einschieben von Einschubkomponenten vor einer Durchbiegung in einer Einschubrichtung geschützt ist.

2. Servereinschub (SE) nach Anspruch 1, wobei die Einbaukäfigvorrichtung zwei oder mehrere Einbaukäfige (EK) aufweist, wobei die Leiterplatte (LP) derart kraftschlüssig an der Einbaukäfigvorrichtung festgelegt ist, dass die Leiterplatte (LP) die Einbaukäfige (EK) mechanisch verbindet und die Einbaukäfige (EK) versteift.

3. Servereinschub (SE) nach Anspruch 1 oder 2, wobei die Leiterplatte (LP) kraftschlüssig an dem Gehäuseboden (GB) festgelegt ist.

4. Servereinschub (SE) nach einem der Ansprüche 1 bis 3,
wobei die Leiterplatte (LP) formschlüssig an der Einbaukäfigvorrichtung angeordnet ist.

5. Servereinschub (SE) nach einem der Ansprüche 1 bis 4,
wobei der Gehäuseboden (GB) wenigstens eine Nut (N) und/oder wenigstens eine Kulissenführung zur formschlüssigen Aufnahme einer Unterseite (US) der Leiterplatte (LP) aufweist.

6. Servereinschub (SE) nach einem der Ansprüche 1 bis 5,
wobei die Leiterplatte (LP) an zwei gegenüberliegenden und zu dem Gehäuseboden (GB) senkrecht angeordneten Gehäusewänden (GWL, GWR) des Einschubgehäuses (EG) formschlüssig angeordnet ist.

7. Servereinschub nach Anspruch 6,
wobei die Gehäusewände (GWL, GWR) jeweils wenigstens eine Nut und/oder wenigstens eine Kulissenführung zur formschlüssigen Aufnahme der Leiterplatte (LP) aufweist.

8. Servereinschub nach einem der Ansprüche 1 bis 7,
wobei die Einbaukäfigvorrichtung einen oder mehrere Dorne (D), insbesondere Führungsdorne und/oder Schraubdorne, aufweist, welche dazu ausgebildet sind, in eine oder mehrere entsprechende Öffnungen (OE) der Leiterplatte (LP) formschlüssig einzugreifen.

## Claims

1. Server insert (SE) for a server rack, having
- an insert housing (EG) with a housing base (GB);
- an installation cage device for receiving insert components which is disposed within the insert housing (EG) on the housing base (GB) and extends substantially across an entire width of the insert housing (EG); and
- a printed circuit board (LP), in particular a backplane or midplane, wherein the printed circuit board (LP) is secured in a force-fitting manner in a plurality of lateral regions on the installation cage device to mechanically reinforce the latter and so as to be substantially perpendicular to the housing base (GB), such that the installation cage device forms a reinforced unit across the width of th insert housing (EG) and reinforcing of the insert housing (EG) is effected, and wherein the printed circuit board is disposed on the housing base (GB) in a form-fitting manner, such that the printed circuit board is protected against deflection in an insertion direction during insertion of insert components.

2. Server insert (SE) according to Claim 1, wherein the installation cage device has two or a plurality of installation cages (EK), wherein the printed circuit board (LP) is secured in a force-fitting manner on the installation cage device in such a manner that the printed circuit board (LP) mechanically connects the installation cages (EK) and reinforces the installation cages (EK).

3. Server insert (SE) according to Claim 1 or 2, wherein the printed circuit board (LP) is secured in a force-fitting manner on the housing base (GB).

4. Server insert (SE) according to one of Claims 1 to 3, wherein the printed circuit board (LP) is disposed in a form-fitting manner on the installation cage device.

5. Server insert (SE) according to one of Claims 1 to 4, wherein the housing base (GB) has at least one groove (N) and/or at least one gate guide for receiving in a form-fitting manner a lower side (US) of the printed circuit board (LP) .

6. Server insert (SE) according to one of Claims 1 to 5, wherein the printed circuit board (LP) is disposed in a form-fitting manner on two mutually opposite housing walls (GWL, GWR) of the insert housing (EG), which are disposed so as to be perpendicular to the housing base (GB).

7. Server insert according to Claim 6, wherein the housing walls (GWL, GWR) have in each case at least one groove and/or at least one gate guide for receiving in a form-fitting manner the printed circuit board (LP).

8. Server insert according to one of Claims 1 to 7, wherein the installation cage device has one or a plurality of pins (D), in particular guide pins and/or screw pins, which are configured for engaging in a form-fitting manner in one or a plurality of corresponding openings (OE) of the printed circuit board (LP).

## Revendications

1. Tiroir de serveur (SE) destiné à un rack de serveur, comportant
- un boîtier de tiroir (EG) équipé d'un fond de boîtier (GB) ;
- un dispositif de cage de montage destiné à recevoir des composants de tiroir, qui est disposé à l'intérieur du boîtier de tiroir (EG) sur le fond de boîtier (GB) et qui s'étend sensiblement sur toute la largeur du boîtier de tiroir (EG) ; et
- une carte de circuit imprimé (LP), en particulier un fond de panier arrière ou central, dans lequel la carte de circuit imprimé (LP) est fixée dans plusieurs zones latérales sensiblement perpendiculaires au fond de boîtier (GB) sur le dispositif de cage de montage pour le rigidifier mécaniquement par complémentarité de force, de manière à ce que le dispositif de cage de montage forme une unité rigidifiée sur la largeur du boîtier de tiroir (EG) et à produire une rigidification du boîtier de tiroir (EG), et dans lequel la carte de circuit imprimé est disposée par complémentarité de forme sur le fond de boîtier (GB) de manière à ce que la carte de circuit imprimé soit protégée contre une déformation dans une direction d'insertion lors de l'insertion de composants de tiroir.

2. Tiroir de serveur (SE) selon la revendication 1, dans lequel le dispositif de cage de montage comprend deux cages de montage (EK) ou plus, dans lequel la carte de circuit imprimé (LP) est fixée par complémentarité de force au dispositif de cage de montage de manière à ce que la carte de circuit imprimé (LP) relie mécaniquement les cages de montage (EK) et rigidifie les cages de montage (EK).

3. Tiroir de serveur (SE) selon la revendication 1 ou 2, dans lequel la carte de circuit imprimé (LP) est fixée par complémentarité de force au fond de boîtier (GB).

4. Tiroir de serveur (SE) selon l'une des revendications 1 à 3, dans lequel la carte de circuit imprimé (LP) est disposée par complémentarité de forme sur le dispositif de cage de montage.

5. Tiroir de serveur (SE) selon l'une des revendications 1 à 4, dans lequel le fond de boîtier (GB) comporte au moins une rainure (N) et/ou au moins un guide à coulisse destiné à recevoir par complémentarité de forme une face inférieure (US) de la carte de circuit imprimé (LP).

6. Tiroir de serveur (SE) selon l'une des revendications 1 à 5, dans lequel la carte de circuit imprimé (LP) est disposée par complémentarité de forme sur deux parois de boîtier opposées (GWL, GWR) du boîtier de tiroir (EG) qui sont disposées perpendiculairement au fond de boîtier (GB).

7. Tiroir de serveur selon la revendication 6, dans lequel les parois de boîtier (GWL, GWR) comportent chacune au moins une rainure et/ou au moins un guide à coulisse pour recevoir la carte de circuit imprimé (LP).

8. Tiroir de serveur selon l'une des revendications 1 à 7, dans lequel le dispositif de cage de montage comporte un ou plusieurs mandrins (D), en particulier des mandrins de guidage et/ou des mandrins à vis, qui sont conçus pour s'engager par complémentarité de forme dans une ou plusieurs ouvertures correspondantes (OE) de la carte de circuit imprimé (LP).
